# EUROPÄISCHE PATENTSCHRIFT

(11) **EP 1 919 725 B1**
(45) Veröffentlichungstag und Bekanntmachung des Hinweises auf die Patenterteilung: **19.01.2011**
(21) Anmeldenummer: 06753283.8
(22) Anmeldetag: 23.06.2006
(51) Int. Cl.: B60H 1/22

(54) **HEIZGERÄT MIT THERMOELEKTRISCHEM MODUL**
HEATING APPARATUS COMPRISING A THERMOELECTRIC MODULE
DISPOSITIF DE CHAUFFAGE A MODULE THERMOELECTRIQUE

(30) Priorität: 23.06.2005 DE 102005029182
(43) Veröffentlichungstag der Anmeldung: 14.05.2008
(73) Patentinhaber: Webasto AG, 82131 Stockdorf (DE)
(72) Erfinder: BUDDE, Jörn, 14471 Potsdam (DE); BAADE, Jens, 01309 Dresden (DE)
(86) Internationale Anmeldenummer: PCT/DE2006/001078
(87) Internationale Veröffentlichungsnummer: WO 2006/136148

(56) Entgegenhaltungen:
- DE-A1- 10 235 601
- US-A- 3 617 390
- US-A- 5 450 869

## Beschreibung

Die Erfindung betrifft ein Heizgerät mit einem ersten Gehäuse, an dessen.Innenseite ein Bereich zur Führung heißer Abgase anschließt, einem zweiten Gehäuse, welches das erste Gehäuse zumindest teilweise umgibt und wobei ein Zwischenraum zwischen dem ersten Gehäuse und dem zweiten Gehäuse von einem zu erwärmenden Medium durchströmt wird, und einem in dem Zwischenraum angeordneten thermoelektrischen Modul (TEM), das geeignet ist, aufgrund einer Temperaturdifferenz zwischen den Abgasen und dem zu erwärmenden Medium eine elektrische Spannung zu erzeugen, wobei gemäß bevorzugten Aspekten das thermoelektrische Modul zwischen dem ersten Gehäuse und einem Wärmetauscher angeordnet ist.

Eine derartige Vorrichtung ist aus der DE 102 35 601 A1 bekannt. Durch die Möglichkeit, mit einer derartigen Vorrichtung Wärmeenergie in elektrische Energie umzuwandeln, gelingt es, die für den Betrieb des Heizgerätes erforderliche elektrische Energie, beispielsweise zur Versorgung eines Gebläses und einer Steuerung, im Heizgerät selbst zu erzeugen. Ebenfalls kann die so erzeugte elektrische Energie anderen Verbrauchern im Kraftfahrzeug zur Verfügung gestellt werden, beispielsweise durch eine Einspeisung in das elektrische Bordnetz. Die in der DE 102 35 601 A1 gezeigte Anordnung weist eine thermoelektrische Einrichtung in Form eines thermoelektrischen Moduls auf, das zwischen einem die "heiße Seite" bildenden ersten Gehäuseabschnitt und einem die "kalte Seite" bildenden Wärmetauscher angeordnet ist. Bei Betrieb des Heizgerätes kann an dem thermoelektrischen Modul somit eine Spannung abgegriffen werden, wobei allerdings Probleme im Hinblick auf die Aufrechterhaltung möglichst hoher Temperaturdifferenzen, thermische Ausdehnungen und eine mangelhafte Wärmeleitfähigkeit zwischen dem thermoelektrischen Modul und dem Gehäuse beziehungsweise dem Wärmetauscher auftreten können.

Die US 5,450,869 zeigt als nächster stand der Technik ebenfalls ein Heizgerät mit einer thermoelektrischen Anordnung. Es wurden bereits Vorkehrungen getroffen, um durch elastische Mittel mechanische und thermische Beanspruchungen der thermoelektrischen Anordnung auszugleichen.

Der Erfindung liegt die Aufgabe zugrunde, die Probleme des Standes der Technik zumindest teilweise zu überwinden und dabei insbesondere die thermischen und mechanischen Verhältnisse der Anordnung zu verbessern.

Diese Aufgabe wird mit den Merkmalen der unabhängigen Ansprüche gelöst.

Vorteilhafte Ausführungsformen der Erfindung sind in den abhängigen Ansprüchen angegeben.

Die Erfindung baut auf dem gattungsgemäßen Heizgerät dadurch auf, dass sich das thermoelektrische Modul über einen Wärmetauscher und elastische Mittel an dem zweiten Gehäuse abstütz, wobei die elastischen Mittel auf der dem zweiten Gehäuse zugewandten Seite des Wärmetauschers angeordnet sind. Durch diese Lagerung des thermoelektrischen Moduls wird eine Verbesserung des Ausgleichs thermisch bedingter Ausdehnungen zur Verfügung gestellt. Das thermoelektrische Modul wird so stabil gehalten, die elastische Lagerung stellt aber eine ausreichende Flexibilität zur Verfügung

Der von dem flüssigen oder gasförmigen Wärmeträgermedium umströmte Wärmetauscher kann die Aufgabe der Bereitstellung einer elastischen Verbindung übernehmen.

In Weiterbildung dieses Gedankens kann vorgesehen sein, dass sich das thermoelektrische Modul über einen Wärmetauscher und eine den Wärmetauscher abstützende mit elastischen Mittel ausgestattete Platte an dem zweiten Gehäuse abstützt.

In diesem Zusammenhang ist es möglich, dass der Wärmetauscher und die mit elastischen Mittel ausgestattete Platte einstückig ausgebildet sind.

Eine einfache und wirkungsvolle Realisierung dieser thermische Ausdehnungen kompensierenden Anordnungen sieht vor, dass die elastische Verbindung Tellerfedern umfasst.

Weiterhin kann vorgesehen sein, dass eine mechanische Verbindung zwischen dem ersten Gehäuse und dem Wärmetauscher ein wärmeisolierendes Material aufweist. Auf diese Weise wird ein unerwünschter Temperaturausgleich zwischen dem ersten Gehäuse und dem Wärmetauscher vermieden, so dass die thermoelektrische Einrichtung mit hohem Wirkungsgrad arbeiten kann.

Beispielsweise kann vorgesehen sein, dass das wärmeisolierende Material Aluminiumoxid und/oder Mullit enthält.

Weiterhin ist es nützlich, dass die mechanische Verbindung zwischen dem ersten Gehäuse und dem Wärmetauscher eine Dichteinrichtung aufweist, die geeignet ist, die thermoelektrische Einrichtung gegen das zu erwärmende Medium abzudichten und thermisch bedingte Ausdehnungen auszugleichen. Die mechanische Verbindung kann somit insbesondere zwei Komponenten aufweisen. Die eine Komponente ist im Hinblick auf die Wärmeisolierung optimiert, die andere Komponente dient der Bereitstellung der nützlichen thermische Ausdehnungen kompensierenden Elastizität. Bei geeigneter Materialauswahl können diese beiden Komponenten in Form einer einheitlichen Komponente realisiert sein, das heißt in Form einer gut wärmeisolierenden elastischen Dichtung.

Ebenfalls ist es möglich, dass das erste Gehäuse und das wärmeisolierende Material und/oder die Dichteinrichtung einstückig ausgebildet sind.

In vergleichbarer Weise kann vorgesehen sein, dass der Wärmetauscher und das wärmeisolierende Material und/oder die Dichteinrichtung einstückig ausgebildet sind. Die Möglichkeit, diese einstückigen Ausbildungen zu realisieren, hängt wiederum von der geeigenten Materialauswahl der verwendeten Bauteile ab.

Ebenfalls ist es möglich, dass zwischen dem thermoelektrischen Modul und dem ersten Gehäuse und/oder zwischen dem thermoelektrischen Modul und dem Wärmetauscher ein Wärmeleitmittel vorgesehen ist. Durch ein solches Wärmeleitmittel werden die Thermoelemente in verbesserter Weise thermisch an die Wärmequelle und die Wärmesenke angebunden.

Dies kann beispielsweise dadurch realisiert sein, dass das Wärmeleitmittel eine Wärmeleitpaste aufweist.

Eine andere Möglichkeit besteht darin, dass das Wärmeleitmittel eine Wärmeleitfolie aufweist.

Die Erfindung wird nun mit Bezug auf die begleitenden Zeichnungen anhand einer bevorzugten Ausführungsform beispielhaft erläutert.

Dabei zeigt:

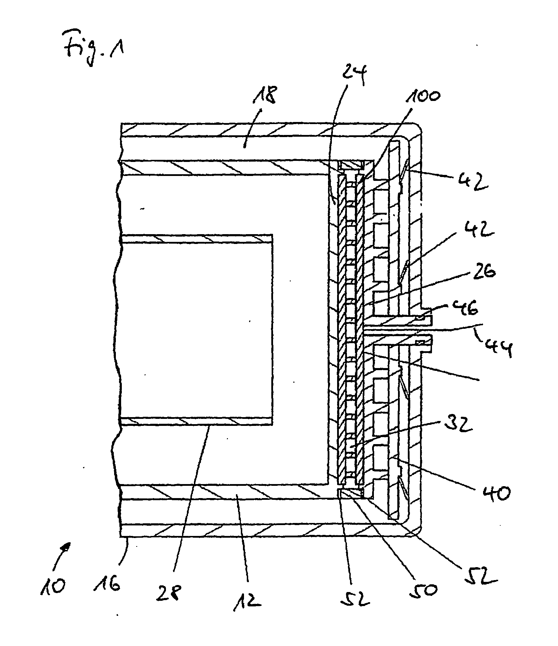

- Figur 1: eine teilweise Schnittansicht eines erfindungsge- mäßen Heizgerätes.

Figur 1 zeigt eine teilweise Schnittansicht eines erfindungsgemäßen Heizgerätes. Das Heizgerät 10, das heißt insbesondere die dargestellte Wärmetauscheranordnung ist im Wesentlichen axialsymmetrisch aufgebaut, wobei ein inneres erstes Gehäuse 12 und ein äußeres zweites Gehäuse 16 vorgesehen sind. Innerhalb der Gehäuse 12, 16 ist ein Flammrohr 28 angeordnet, wobei aus dem Flammrohr 28 austretende Abgase die Innenseite des ersten Gehäuses 12 erwärmen. Zwischen dem ersten Gehäuse 12 und dem zweiten Gehäuse 16 ist ein Zwischenraum 18 vorgesehen, der durch ein Wärmeträgermedium, beispielsweise Wasser, durchströmt wird, so dass das erste Gehäuse 12 als Wärmetauscher zur Übertragung von Verbrennungswärme auf das Wärmeträgermedium fungiert. An einem Boden des ersten Gehäuses 12, der als Wärmekontaktabschnitt 24 vorgesehen ist, ist ein thermoelektrisches Modul 100 angeordnet. Das thermoelektrische Modul 100 steht über ein wärmeleitfähiges Medium, beispielsweise eine Paste oder eine Folie, mit dem Wärmekontaktabschnitt 24 des ersten Gehäuses 12 in Verbindung. Auf der anderen Seite steht das thermoelektrische Modul 100 mit einem Wärmetauscher 26 in Verbindung, der in dem Zwischenraum 18 zwischen dem ersten Gehäuse 12 und dem zweiten Gehäuse 16 angeordnet ist. Der Wärmetauscher 26 ist über einen wärmeisolierenden Ring 50 mit dem ersten Gehäuse 12 verbunden. Dieser kann beispielsweise aus Aluminiumoxid oder Mullit bestehen. Um zu verhindern, dass das Wärmeträgermedium in den Zwischenraum 32 zwischen dem ersten Gehäuse 12 und dem Wärmetauscher 26 einbringt, ist an beiden Seiten des wärmeisolierenden Ringes 50 ein Dichtring 52 vorgesehen. Bei geeigneter Materialauswahl können der wärmeisolierende Ring und die Dichteinrichtung in einem Bauteil ausgeführt sein. Der Wärmetauscher 26 stützt sich über eine mit Tellerfedern 42 ausgestattete Platte 40 am zweiten Gehäuse 16 ab. Hierdurch steht eine stabile Anordnung zur Verfügung, wobei durch geeignete Auslegung der Federkräfte ein sicherer thermischer Kontakt zwischen dem thermoelektrischen Modul 100 und de ersten Gehäuse 12 sowie dem Wärmetauscher 26 zur Verfügung steht. Der Wärmetauscher 26 steht auch noch im Bereich des elektrischen Anschlusses 44 mit dem zweiten Gehäuse 16 in Verbindung, und er wird dort von diesem gehalten. Die Verbindung wird über eine Dichtung 46 vermittelt.

### Bezugszeichenliste:

- 10: Heizgerät
- 12: Gehäuse
- 14: Bereich
- 16: Gehäuse
- 18: Zwischenraum
- 24: Wärmekontaktabschnitt
- 26: Wärmetauscher
- 28: Flammrohr

- 32: Zwischenraum
- 40: Platte
- 42: Tellerfeder
- 44: Anschluss
- 50: wärmeisolierendes Material
- 52: Dichteinrichtung
- 100: Thermoelektrisches Modul

## Patentansprüche

1. Heizgerät (10) mit
- einem ersten Gehäuse (12), an dessen Innenseite ein Bereich (14) zur Führung heißer Abgase anschließt,
- einem zweiten Gehäuse (16), welches das erste Gehäuse zumindest teilweise umgibt und wobei ein Zwischenraum (18) zwischen dem ersten Gehäuse und dem zweiten Gehäuse von einem zu erwärmenden Medium durchströmt wird, und
- einem in dem Zwischenraum (18) angeordneten thermoelektrischen Modul (TEM) (100), das geeignet ist, aufgrund einer Temperaturdifferenz zwischen den Abgasen und dem zu erwärmenden Medium eine elektrische Spannung zu erzeugen,
**dadurch gekennzeichnet, dass** sich das thermoelektrische Modul (100) über einen Wärmetauscher (26) und elastische Mittel (42) an dem zweiten Gehäuse (16) abstützt, wobei die elastischen Mittel (42) auf der dem zweiten Gehäuse zugewandten Seite des Wärmetauschers (26) angeordnet sind.

2. Heizgerät nach Anspruch 1, **dadurch gekennzeichnet, dass** sich das thermoelektrische Modul (100) über einen Wärmetauscher (26) und eine den Wärmetauscher abstützende mit elastischen Mittel (42) ausgestattete Platte (40) an dem zweiten Gehäuse abstützt.

3. Heizgerät nach Anspruch 2, **dadurch gekennzeichnet, dass** der Wärmetauscher und die mit elastischen Mittel ausgestattete Platte einstückig ausgebildet sind.

4. Heizgerät nach einem der vorhergehenden Ansprüche, **dadurch gekennzeichet, dass** die elastische Verbindung Tellerfedern (42) umfasst.

5. Heizgerät (10) nach einem der vorhergehenden Ansprüche, **dadurch gekennzeichnet, dass** eine mechanische Verbindung zwischen dem ersten Gehäuse (12) und dem wärmetauscher (26) ein wärmeisolierendes Material (50) aufweist.

6. Heizgerät nach Anspruch 5, **dadurch gekennzeichnet, dass** das wärmeisolierende Material Aluminiumoxid und/oder Mullit enthält.

7. Heizgerät nach Anspruch 6, **dadurch gekennzeichnet, dass** die mechanische Verbindung zwischen dem ersten Gehäuse und dem Wärmetauscher eine Dichteinrichtung (52) aufweist, die geeignet ist, das thermoelektrische Modul (100) gegen das zu erwärmende Medium abzudichten und thermisch bedingte Ausdehnungen auszugleichen.

8. Heizgerät nach Anspruch 7, **dadurch gekennzeichnet, dass** das erste Gehäuse und das wärmeisolierende Material und/oder die Dichteinrichtung einstückig ausgebildet sind.

9. Heizgerät nach Anspruch 7 oder 8, **dadurch gekennzeichnet, dass** der Wärmetauscher und das wärmeisolierende Material und/oder die Dichteinrichtung einstückig ausgebildet sind.

10. Heizgerät (10) nach einem der vorhergehenden Ansprüche, **dadurch gekennzeichnet, dass** zwischen dem thermoelektrischen Modul (100) und dem ersten Gehäuse (12) und/oder zwischen dem thermoelektrischen Modul (100) und dem Wärmetauscher (26) ein Wärmeleitmittel vorgesehen ist.

11. Heizgerät nach Anspruch 10, **dadurch gekennzeichnet, dass** das Wärmeleitmittel eine Wärmeleitpaste aufweist.

12. Heizgerät nach Anspruch 10 oder 11, **dadurch gekennzeichnet, dass** das Wärmeleitmittel eine Wärmeleitfolie aufweist.

## Claims

1. Heating apparatus (10), with
- a first housing (12), the inside of which has adjacent to it a region (14) for the routing of hot exhaust gases,
- a second housing (16), which at least partially surrounds the first housing, a medium to be heated flowing through an interspace (18) between the first housing and the second housing, and
- a thermoelectric module (TEM) (100) which is arranged in the interspace (18) and is suitable for generating an electrical voltage by virtue of a temperature difference between the exhaust gases and the medium to be heated,
**characterized in that** the thermoelectric module (100) is supported on the second housing (16) via a heat exchanger (26) and elastic means (42), the elastic means (42) being arranged on the side of the heat exchanger (26) facing the second housing.

2. Heating apparatus according to Claim 1, **characterized in that** the thermoelectric module (100) is supported on the second housing via a heat exchanger (26) and a plate (40) supporting the heat exchanger and equipped with elastic means (42).

3. Heating apparatus according to Claim 2, **characterized in that** the heat exchanger and the plate equipped with elastic means are produced in one piece.

4. Heating apparatus according to one of the preceding claims, **characterized in that** the elastic connection comprises cup springs (42).

5. Heating apparatus (10) according to one of the preceding claims, **characterized in that** a mechanical connection between the first housing (12) and the heat exchanger (26) has a heat-insulating material (50).

6. Heating apparatus according to Claim 5, **characterized in that** the heat-insulating material contains aluminum oxide and/or mullite.

7. Heating apparatus according to claim 6, **characterized in that** the mechanical connection between the first housing and the heat exchanger has a sealing device (52) which is suitable for sealing off the thermoelectric module (100) with respect to the medium to be heated and for compensating thermally induced expansions.

8. Heating apparatus according to Claim 7, **characterized in that** the first housing and the heat-insulating material and/or the sealing device are produced in one piece.

9. Heating apparatus according to Claim 7 or 8, **characterized in that** the heat exchanger and the heat-insulating material and/or the sealing device are produced in one piece.

10. Heating apparatus (10) according to one of the preceding claims, **characterized in that** a heat conduction means is provided between the thermoelectric module (100) and the first housing (12) and/or between the thermoelectric module (100) and the heat exchanger (26).

11. Heating apparatus according to Claim 10, **characterized in that** the heat conduction means has a heat conduction paste.

12. Heating apparatus according to Claim 10 or 11, **characterized in that** the heat conduction means has a heat conduction foil.

## Revendications

1. Dispositif de chauffage (10) comprenant :
- un premier boîtier (12), sur le côté intérieur duquel se raccorde une région (14) pour le guidage de gaz d'échappement chauds,
- un deuxième boîtier (16), qui entoure au moins en partie le premier boîtier et un espace intermédiaire (18) entre le premier boîtier et le deuxième boîtier étant parcouru par un milieu à réchauffer, et
- un module thermoélectrique (TEM) (100) disposé dans l'espace intermédiaire (18), lequel est approprié pour produire une tension électrique sur la base d'une différence de température entre les gaz d'échappement et le milieu à réchauffer,
**caractérisé en ce que** le module thermoélectrique (100) s'appuie par le biais d'un échangeur de chaleur (26) et de moyens élastiques (42) sur le deuxième boîtier (16), les moyens élastiques (42) étant disposés sur le côté de l'échangeur de chaleur (26) opposé au deuxième boîtier.

2. Dispositif de chauffage selon la revendication 1, **caractérisé en ce que** le module thermoélectrique (100) s'appuie contre le deuxième boîtier par le biais d'un échangeur de chaleur (26) et d'une plaque (40) supportant l'échangeur de chaleur et munie de moyens élastiques (42).

3. Dispositif de chauffage selon la revendication 2, **caractérisé en ce que** l'échangeur de chaleur et la plaque munie de moyens élastiques sont réalisés d'une seule pièce.

4. Dispositif de chauffage selon l'une quelconque des revendications précédentes, **caractérisé en ce que** la connexion élastique comprend des ressorts Belleville (42).

5. Dispositif de chauffage (10) selon l'une quelconque des revendications précédentes, **caractérisé en ce qu'**une connexion mécanique entre le premier boîtier (12) et l'échangeur de chaleur (26) présente un matériau calorifuge (50).

6. Dispositif de chauffage selon la revendication 5, **caractérisé en ce que** le matériau calorifuge contient de l'oxyde d'aluminium et/ou de la mullite.

7. Dispositif de chauffage selon la revendication 6, **caractérisé en ce que** la connexion mécanique entre le premier boîtier et l'échangeur de chaleur présente un dispositif d'étanchéité (52), qui est approprié pour étancher le module thermoélectrique (100) contre le milieu à réchauffer et pour compenser les dilatations thermiques.

8. Dispositif de chauffage selon la revendication 7, **caractérisé en ce que** le premier boîtier et le matériau calorifuge et/ou le dispositif d'étanchéité sont réalisés d'une seule pièce.

9. Dispositif de chauffage selon la revendication 7 ou 8, **caractérisé en ce que** l'échangeur de chaleur et le matériau calorifuge et/ou le dispositif d'étanchéité sont réalisés d'une seule pièce.

10. Dispositif de chauffage (10) selon l'une quelconque des revendications précédentes, **caractérisé en ce qu'**un milieu thermoconducteur est prévu entre le module thermoélectrique (100) et le premier boîtier (12) et/ou entre le module thermoélectrique (100) et l'échangeur de chaleur (26).

11. Dispositif de chauffage selon la revendication 10, **caractérisé en ce que** le milieu thermoconducteur présente une pâte thermoconductrice.

12. Dispositif de chauffage selon la revendication 10 ou 11, **caractérisé en ce que** le milieu thermoconducteur présente une feuille thermoconductrice.
